# EUROPEAN PATENT APPLICATION

(11) **EP 0 650 202 A1**
(43) Date of publication of application: **26.04.1995**
(21) Application number: 94307801.4
(22) Date of filing: 25.10.1994
(51) Int. Cl.: H01L 33/00

(54) **Semiconductor luminous element and devices using same**

(30) Priority: 25.10.1993 JP 289934/93; 04.03.1994 JP 60330/94
(71) Applicant: OMRON CORPORATION, Kyoto 616 (JP)
(72) Inventor: Imamoto, Hiroshi, Tsukuba-city, Ibaraki-ken 305 (JP); Watanabe, Hideaki, Tsukuba-city, Ibaraki-ken 305 (JP); Imanaka, Koichi, Tsukuba-city, Ibaraki-ken 305 (JP); Tanaka, Tsuguji, Ibaraki-city, Osaka-fu 567 (JP); Yanagase, Masashi, Tsukuba-city, Ibaraki-ken 305 (JP)
(74) Representative: Calderbank, Thomas Roger

(57) **Abstract**

A semiconductor luminous element is a surface-emitting type element with a microscope luminous region and has a constricted current path, which is formed so that the current flows only in the region directly below a window (28). The window (28) is formed in the center of a p-electrode (32). The p-electrode includes a segment (32a), which surrounds the window, and a segment (32b) of thin bands of electrode which traverse the window in the form of a cross, dividing it into four equal regions. As a result, there is no drop in luminous output in the center of the window (28), and the total luminous output is enhanced.

## Description

The invention concerns a semiconductor luminous element of the type which emits light from its surface. This luminous element has a high output and a luminous surface of microscopic dimensions. Such elements are essential in the fields of optical communication and optical data processing. The invention concerns a luminous device, a photocoupler, an optical detector, an optical data processor, a photoemissive device and an optical fiber module which employ the said semiconductor luminous element.

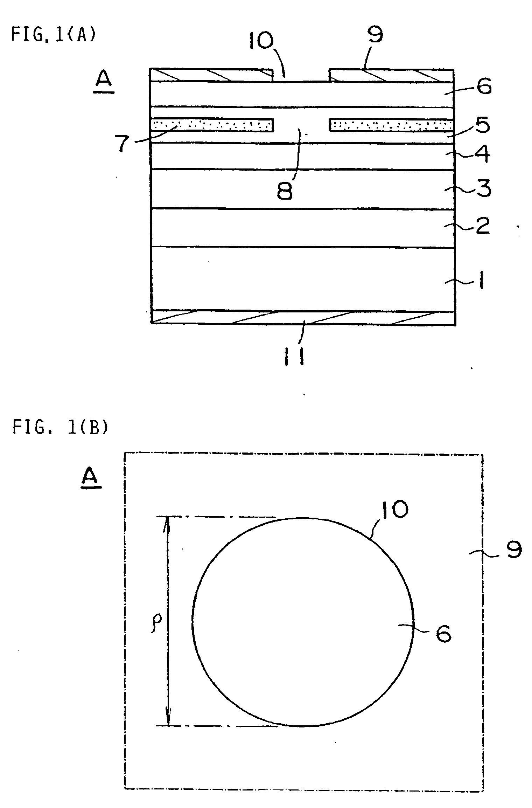

Figures 1 (a) and (b) show a cross section and a partially cut away magnified plan view of a surface-emitting type semiconductor luminous element with a microscopic luminous area. Semiconductor luminous element A consists of n-lower cladding layer 2, which covers the surface of n-semiconductor substrate 1; p-active layer 3; p-upper cladding layer 4; p-upper cladding layer 5; p-cap layer 6, which is epitaxially grown as a succession of layers; and layer 7 of reversed conductivity, which is formed after cap layer 6 has been completed by injecting n-type ions into all of upper cladding layer 5 except the central portion, which can then serve as current path 8. Electrode 9 on the p side is formed on the upper surface of cap layer 6. Window 10, through which the light can exit, is provided in electrode 9 in line with the current path. Electrode 11, on the n side, is formed on the lower surface of semiconductor substrate 1.

When voltage is applied between electrode 9 on the p side and electrode 11 on the n side, the plane consisting of the lower surface of reversed layer 7 and upper cladding layer 5 assumes an opposite bias, causing the current to flow only in current path 8, which is surrounded by layer 7. The current is thus caused to flow only to the region of active layer 3 which is directly in line with current path 8, and only this region will emit light. Thus, semiconductor luminous element A uses a constricted current design.

With a semiconductor luminous element A as shown in Figures 1 (a) and (b), the current is concentrated between cap layer 6 and p-electrode 9 on the inner periphery of electrode 9. If the diameter of the luminous region is, for example, 50 µm, the luminous output in the center of window 10 will be nearly 90% lower than that of the periphery, resulting in a ring-shaped pattern of light emission.

Another problem is that the most intense light is concentrated directly below p-electrode 9 just outside window 10. The light emitted by active layer 3, then, is reflected by the lower surface of p-electrode 9, which decreases the luminous efficiency of the element. This has been addressed by increasing the relative size of the luminous region created by the current path, or by choosing a material for the semiconductor which did not allow the current to be conducted over a wide area. However, as neither of these schemes allowed sufficient current to be supplied to the center of the luminous region, they were unable to contribute to light emission, and luminous efficiency remained low. There was thus a need for improvement in the efficiency of light output.

The invention described herein was developed in view of the aforementioned deficiencies in semiconductor luminous elements. An object of the invention is to increase the amount of current conducted into the center of the exit window without decreasing the light output, and in this way to realize a semiconductor luminous element which has a high external quantum efficiency despite its microscopic luminous area.

A further objective is to provide a high-resolution luminous device, a photocoupler, an optical detector, an optical data processor, a photoemissive device and an optical fiber module which employ such a semiconductor luminous element as their light source.

One semiconductor luminous element according to the invention is a surface-emitting type element with a luminous area of microscopic diameter. It has, on the surface of a semiconductor chip which contains a luminous layer, a window through which light can escape. Around the aforesaid window is an electrode to conduct a current to the luminous layer. A distinguishing feature of the first luminous element according to the invention is the fact that an electrode is provided in a portion of the window.

A second semiconductor luminous element according to the invention is a surface-emitting type element with a luminous area of microscopic diameter. It has, on the surface of a semiconductor chip which contains a luminous layer, a window through which light can escape. Around the aforesaid window is an electrode to conduct a current to the luminous layer. A distinguishing feature of this second luminous element according to the invention is the fact that electrodes crisscross the window in such a way as to subdivide it into virtually uniform portions.

A third semiconductor luminous element according to the invention is a surface-emitting type element with a luminous area of microscopic diameter. It has, on the surface of a semiconductor chip which contains a luminous layer, a window through which light can escape. Around the aforesaid window is an electrode to conduct a current to the luminous layer. A distinguishing feature of the third luminous element according to the invention is the fact that the window includes numerous round exit holes, each of whose surface area is less than that of the window.

In each of the semiconductor luminous elements described above, it is desirable that the aforesaid current should flow directly below the escape window and nowhere else. To constrict the current so that it does not flow directly below the electrode surrounding the window, but does flow below the window, ions can be injected into the semiconductor chip. As an alternative to ion injection, a diffusion scheme to produce a constricted current can be used. A third alternative is to create a constriction by etching away the material of the semiconductor chip which lies below the window's surround.

In the semiconductor luminous element described above, the semiconductor chip may have an escape window for the luminous layer, and opposite the luminous layer, multiple layers joined in a hetero structure whose refractive index is lower than that of the luminous layer. If this multilayer film has an emission wavelength λ₀ and a refractive index n, it will be composed of thin films whose thickness d is equal to λ₀/(4n). It could also be composed of films whose thickness d is less than λ₀/(4n). Another alternative is to use a multilayer film composed of reflective film capable of optical interference, and using a number of types of thin film.

A fourth semiconductor luminous element according to the invention is a surface-emitting type element which has a current path formed on the semiconductor chip to conduct the current to only a portion of the luminous layer. An electrode is provided on the surface of the semiconductor chip to apply a current to the luminous layer by way of the current path. A distinguishing fourth luminous element according to the invention is the fact that the aforesaid electrode is formed on a portion of the luminous region on the surface of the aforesaid chip, and the fact that no electrode is provided outside the luminous region.

In this semiconductor luminous element, the aforesaid electrode on the surface of the aforesaid semiconductor chip can be formed of at least one electrode pattern extending from outside the aforesaid luminous area toward its center. It is also possible for the aforesaid electrode to be omitted from the central portion of the luminous region on the surface of the aforesaid semiconductor chip. The aforesaid electrode need not be designed in such a way as to partition the aforesaid luminous region.

In this same fourth luminous element according to the invention, the aforesaid current constriction can be achieved by ion injection or by scattering impurities to form the aforementioned current path. Alternatively, the current can be made to flow only directly below the luminous region by etching away the material below the surround.

In this fourth luminous element according to the invention, the aforesaid semiconductor chip can have a reflective multilayer film on the side of the luminous layer which is opposite the direction of emission. Each thin film comprising the reflective multilayer films should be composed of films of various thicknesses.

The aforesaid semiconductor luminous element could be used as a light source in a luminous device or lamp, a photocoupler, an optical detector, an optical data processor, or an optical fiber module.

The first through third semiconductor luminous elements according to the invention are surface-emitting elements with luminous regions of microscopic diameter. More precisely, they are luminous elements designed so that the path which the current can take is circumscribed. These elements have an electrode in a portion of the escape window or an electrode pattern crisscrossing it. Alternatively, the window is composed of numerous tiny holes. With these configurations, current can be supplied to the luminous layer not only from the electrode surrounding the window, but also from the electrode in the window. As a result, the light is emitted uniformly across the entire window and in the direction it faces. There is no decrease in light output in the center of the window. This produces a uniform emission pattern and increases the luminous efficiency.

If a multilayer film composed of thin films with an emission wavelength of 1/(4n) is formed on the side of the luminous layer which does not face the escape window, the light emitted by the luminous layer in the direction opposite the escape window can be reflected by the film and conducted to the exterior. This will further enhance the luminous efficiency.

If a multilayer film is used which contains thin films whose emission wavelength is less than 1/(4n), the light emitted by the luminous layer obliquely in the direction opposite the escape window will also be reflected. This light, too, will be conducted through the escape window, further improving the luminous efficiency.

The fourth semiconductor luminous element according to the invention is also designed so that the current flow is constricted. It has an electrode formed on a portion of the luminous region on its surface. The electrode in the luminous region supplies current uniformly to every part of the luminous layer so that there is no decrease in light output in the center of the luminous region. A uniform emission pattern is achieved and efficiency of emission is enhanced. The shape of the electrode can be varied to increase the luminous efficiency as well as the maximum light output. Since the area outside the luminous region has no electrode, current delivered from the periphery of the luminous region can be minimized. By the same token, the amount of current supplied by the electrode in the luminous region is increased. This scheme improves the efficiency of emission in the luminous region, increases the maximum light output, and eliminates a ring-shaped pattern of emission. To achieve such a configuration, the electrode should consist of at least one electrode pattern extending from outside the luminous region toward its center.

When no part of the electrode is placed in the center of the luminous region, the light which is emitted there will not be obstructed by an electrode. This prevents a decrease in intensity at the center of the region.

When the electrode does not partition the luminous region, the unnecessary portions of the electrode film can be removed easily when the electrode is produced by means of the lift-off method, thus facilitating the manufacture of the electrode.

When a reflective multilayer film is provided on the side of the luminous layer opposite the desired direction of emission, the light emitted by that layer in the opposite direction can be reflected by that film. In this way, the quantity of light emitted to the exterior by the luminous region can be increased, thus improving the external quantum efficiency.

When the aforesaid semiconductor luminous element is used as a light source in a luminous or photoemissive device, a photocoupler, an optical detector, an optical data processor, or an optical fiber module, it will improve the resolution of that device.

In the drawings:

Figures 1 (a) and (b) show a cross section and a partial cut away, enlarged plan view of a related art semiconductor luminous element.

Figures 2 (a) and (b) show a cross section and a cut-away enlarged plan view of a semiconductor luminous element according to an embodiment of the invention.

Figure 3 (a) is a graph showing the relationship of current supplied and luminous output in a related art semiconductor luminous element. Figure 3 (b) is a graph showing the relationship of current supplied and luminous output in a semiconductor luminous element according to the invention.

Figures 4 (a) through (f) show various patterns for the exit window.

Figure 5 shows a cross section of a semiconductor luminous element which is another embodiment according to the invention.

Figure 6 shows a cross section of a semiconductor luminous element which is yet another embodiment according to the invention.

Figure 7 is a graph of the reflective spectrum of the multilayer reflective film in a semiconductor luminous element which is yet another embodiment according to the invention.

Figures 8 (a) and (b) show a cross section of a semiconductor luminous element which is yet another embodiment according to the invention and a plan view of the vicinity of its window.

Figure 9 (a) shows a microscopic view of the vicinity of the window on the aforesaid semiconductor luminous element. Figures 9 (b) and (c) show the distribution of luminous intensity along line X₁-X₁ and line Y₁-Y₁.

Figures 10 (a) and (b) show a cross section of a related art semiconductor luminous element and a plan view of the vicinity of its window.

Figure 11 (a) shows a microscopic view of the vicinity of the window on the aforesaid semiconductor luminous element. Figures 11 (b) and (c) show the distribution of luminous intensity along line X₂-X₂ and line Y₂-Y₂.

Figures 12 (a) and (b) show a cross section of a semiconductor luminous element which is yet another embodiment according to the invention and a plan view of the vicinity of its window.

Figure 13 (a) shows a microscopic view of the vicinity of the window on the aforesaid semiconductor luminous element. Figures 13 (b) and (c) show the distribution of luminous intensity along line X₃-X₃ and line Y₃-Y₃.

Figure 14 is a plan view of a semiconductor luminous element which is yet another embodiment according to the invention.

Figure 15 (a) shows a microscopic view of the vicinity of the window on the aforesaid semiconductor luminous element. Figures 15 (b) and (c) show the distribution of luminous intensity along line X₄-X₄ and line Y₄-Y₄.

Figure 16 is a plan view of a semiconductor luminous element which is yet another embodiment according to the invention.

Figure 17 (a) shows a microscopic view of the vicinity of the window on the aforesaid semiconductor luminous element. Figures 17 (b) and (c) show the distribution of luminous intensity along line X₅-X₅ and line Y₅-Y₅.

Figure 18 shows a cross section of a differently configured semiconductor chip which could be used in any of the luminous elements pictured in Figures 8 through 17.

Figure 19 shows a cross section of another differently configured semiconductor chip which could be used in any of the luminous elements pictured in Figures 8 through 17.

Figure 20 shows a cross section of yet another differently configured semiconductor chip which could be used in any of the luminous elements pictured in Figures 8 through 17.

Figure 21 shows a cross section of yet another differently configured semiconductor chip which could be used in any of the luminous elements pictured in Figures 8 through 17.

Figures 22 (a), (b) and (c) show a perspective view, a horizontal cross section, and a lateral cross section of a photoemissive device which uses the semiconductor luminous element according to the invention.

Figure 23 is a cut-away perspective view of a related art photoemissive device.

Figure 24 is a cross section of a single-plane photocoupler which uses a semiconductor luminous element according to the invention.

Figure 25 is a cross section of a pointer which uses a semiconductor luminous element according to the invention.

Figure 26 (a) is a perspective view of a rotary encoder which uses a semiconductor luminous element according to the invention. Figure 26 (b) is a waveform diagram showing the phase A signal and the phase B signal from the same encoder.

Figure 27 is a simplified drawing of a distance sensor which uses a semiconductor luminous element according to the invention.

Figure 28 shows a sample result of a measurement made by the same distance sensor.

Figure 29 is a perspective view of a laser beam printer which uses a semiconductor luminous element according to the invention.

Figure 30 (a) is a perspective view of a bar code reader which uses the semiconductor luminous element according to the invention. Figure 30 (b) shows the detection signal produced by this bar code reader.

Figures 31 (a) through (g) are simplified drawings of various optical fiber modules incorporating the invention.

Figure 32 is a graph of the theoretical limit values for coupling efficiency in direct-coupling type and lens-coupling type optical fiber modules.

Figure 33 (a) is a simplified drawing of a sensor using optical fibers. Figure 33 (b) is a graph showing how the detector output changes with the distance of the object.

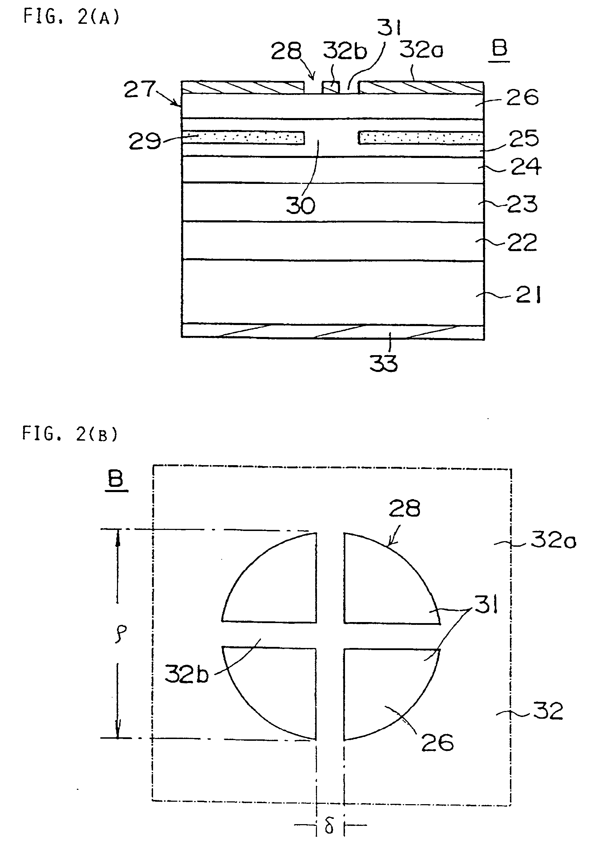

Figures 2 (a) and (b) show a cross section and a partially cut away magnified plan view of semiconductor luminous element B, according to an embodiment of the invention. Luminous element B shall be described following the order of its manufacture. On top of n-GaAs substrate 21, a 1 µm-thick n-AlGaInP lower cladding layer 22 is epitaxially grown, followed by a 1 µm-thick p-GaInP active layer 23 (the emitting layer); a 0.5 µ-thick p-AlGaInP upper cladding layer 24; p-AlGaAs upper cladding layer 25; a 0.2 µm-thick p-GaAs cap layer 26. This completes the initial production of semiconductor chip 27. To form window 28, the portion of the upper surface of cap layer 26 where the window is to be formed is coated with AZ resist (not pictured). With the resist serving as a mask, n-type ions are injected into semiconductor chip 27. The n-type ions are injected in such a way that the upper and lower bounds of the injected region fall within upper cladding layer 25. This has the effect of creating an n-type reversed layer (the region where the ions have been injected) 29 within upper cladding layer 25. The area where reversed layer 29 is not formed then becomes current path 30. The n-type ions should be injected to a depth such that they do not reach the border between upper cladding layers 25 and 24. The aforesaid AZ resist is then removed, and a new coating of AZ resist (not pictured) is applied on the upper surface of cap layer 26 conforming to the shapes of apertures 31 on window 28. A metal which can act as an electrode is then deposited from above, and p-electrode 32 is formed using the lift-off method. In this way window 28 is formed directly in line with current path 30.

As can be seen in Figure 2 (b), p-electrode 32 includes portion 32a, which surrounds window 28 (thus conforming to reversed layer 29), and portion 32b, which traverses window 28 in the shape of a cross, subdividing it into equal segments. N-electrode 33 is formed on the lower surface of GaAs substrate 21.

When voltage is applied between p-electrode 32 and n-electrode 33, the pn composition surfaces between reversed layer 29 and upper cladding layer 25 assume an opposite bias. The current from p-electrode 32 flows only in current path 30, which is enclosed by reversed layer 29. It is thus conducted only to the region of active layer 23, which corresponds to current path 30, causing that region to luminesce. The light emitted by active layer 23 is conducted to the exterior through apertures 31 on window 28. Semiconductor luminous element B, then, has a design based on constricting the current. Furthermore, because current is supplied to active layer 23 not only via the inner edge of portion 32a, the portion of the electrode on the outside of window 28, but also via portion 32b, the part of the electrode within the window, there is no decrease in luminous output at the center of window 28. This design, then, enhances the luminous efficiency of semiconductor luminous element B. It is possible for reversed layer 29 to be eliminated from this embodiment. If this were done, the luminous efficiency would suffer in comparison to an element with a reversed layer 29; however, it would eliminate the drop in luminous output in the center of window 28.

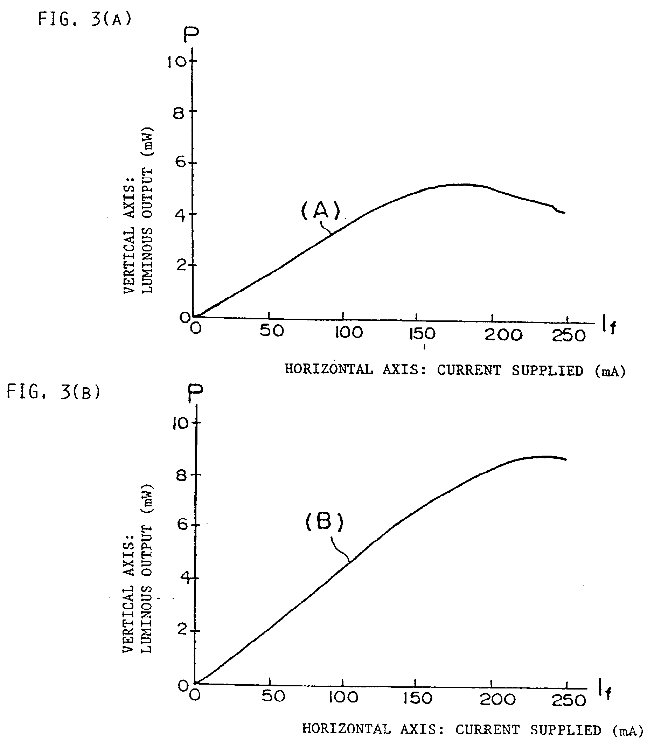

Figure 3 (a) shows the relationship between current I_{f} and luminous output P in a related art semiconductor luminous element A as shown in Figure 1 (b), which has a window 28 with a round aperture 50 µm in diameter. Figure 3 (b) shows the relationship between current I_{f} and luminous output P in the semiconductor luminous element B of this embodiment, which has a window 28 50 µm in diameter traversed by a 4 µm-thick cross-shaped electrode portion 32b. Comparing Figures 3 (a) and (b), illustrates that semiconductor luminous element B, according to this embodiment of the invention, has an 80% greater luminous output than the related art luminous element A. In addition, the saturation current Iₛ for luminous output is higher in element B.

In the embodiment pictured in Figures 2 (a) and 2 (b), reversed layer 29, which serves to obstruct the current, was formed by ion injection. It is possible to create this layer by scattering impurities. In the embodiment, the upper surface of reversed layer 29 lies within upper cladding layer 25. It is equally possible to place this layer within or on top of cap layer 26.

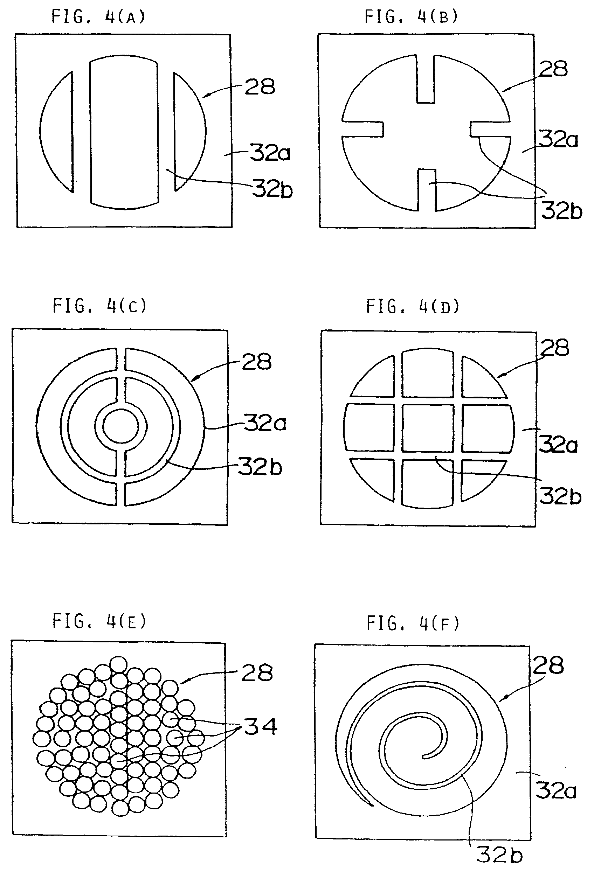

The shape of electrode segment 32b in window 28 is not limited to that shown in Figure 2 (b). Any desired shape could be used. Some examples of possible shapes are shown in Figures 4 (a) through (f). Figure 4 (a) shows a segment 32b with an electrode pattern including two parallel bands traversing window 28. In Figure 4 (b), segment 32b has an electrode pattern which protrudes from the inner edge of portion 32a, the portion surrounding window 28, into the window. Figure 4 (c) shows a segment 32b in which annular and straight line electrode patterns are combined. The segment 32b shown in Figure 4 (d) has an electrode pattern of parallel crosses. In Figure 4 (e), window 28 is formed of a mass of pinpoint apertures 34. In Figure 4 (f), segment 32b has a spiral electrode pattern. An electrode segment employing any of these patterns will have the same effect as that used in the semiconductor luminous element B pictured in Figure 2.

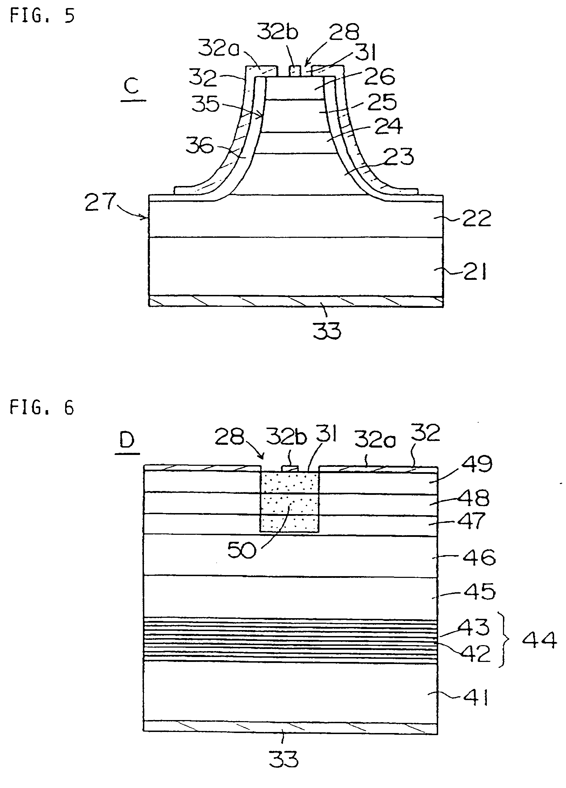

Figure 5 is a cross section of semiconductor luminous element C, another embodiment according to the invention. In this embodiment, semiconductor chip 27 (from GaAs substrate 21 to cap layer 26) is initially produced by growing crystals just, as in Figures 2 (a) and 2 (b). The part of chip 27 outside window 28 is then etched away from cap layer 26 to lower cladding layer 22, leaving only mesa 35, the region under window 28. An insulating film 36 of SiO₂ or some similar substance is applied from the highest point of the sides of the mesa to the upper surface of lower cladding layer 22. P-electrode 32 is formed on top of insulating film 36 so that it covers the sides of mesa 35 and comes in contact with the upper surface of cap layer 26. In this way a window 28 is formed on top of cap layer 26, and an electrode segment 32b like that in Figures 2 (a) and 2 (b) or like one of the patterns in 4 (a) through (f) can be created in that window.

In this embodiment, the current path is confined to mesa 35, the region directly below window 28. Current is conveyed to active layer 23 both from electrode segment 32a, which surrounds window 28, and from electrode segment 32b, which is inside the window. This prevents a decrease in luminous output in the center of window 28, thus improving the luminous efficiency of semiconductor luminous element C and enhancing its total luminous output.

Figure 6 is a cross section of semiconductor luminous element D, yet another embodiment according to the invention. In semiconductor luminous element D, MBE or MOCVD is used to grow epitaxially on n-GaAs substrate 41, in order, multilayer reflective film 44 (Distributed Bragg Reflection, or DBR, film), comprising thirty pairs of Al_{0.1}Ga_{0.9}As layer 42 and AlAs layer 43 stacked one atop the other; 1 µm-thick n-Al_{0.45}Ga_{0.55}As lower cladding layer 45; 1 µm-thick p-Al_{0.03}Ga_{0.97}As active layer 46; 0,5 µm-thick p-Al_{0.45}Ga_{0.55}As upper cladding layer 47; n-AlGaAs current block layer 48; and 0.2 µm-thick p-GaAs cap layer 49.

The AlGaAs layers 42 contained in multilayer reflective film 44 have a refractive index of n₁, and a thickness of 1/(4n₁) the wavelength 50 nm shorter (800 nm) than the wavelength λ₀ of the emitted light (= 850 nm). AlAs layers 43 have a refractive index of n₂ and a thickness of 1/(4n₂) of the same wavelength (800 nm). In this example, thirty pairs of AlGaAs layer 42 and AlAs layer 43 are used; however, there is no limitation on the composition of multilayer reflective film 44 nor on the number of pairs used.

Next, Zn is scattered on the portion of the upper surface of cap layer 49 which is to become window 28 (for example, an area 50 µm in diameter in the center of cap layer 49). P-type current path 50 is formed, extending from the top of cap layer 49 through current block layer 48 to somewhere below the border between layer 48 and upper cladding layer 47. An AZ resist (not pictured) is applied to the upper surface of cap layer 49 in a pattern conforming to the intended shape of aperture 31 on window 28. A metal to serve as an electrode is deposited from above, and p-electrode 32 is formed using the lift-off method. Thus window 28 is formed in line with current path 50. P-electrode 32 includes segment 32a, which surrounds window 28, and segment 32b, the portion of the electrode inside the window, which may have the shape pictured in Figure 2 (b) or that in any of Figures 4 (a) through (f). N-electrode 33 is formed on the lower surface of GaAs substrate 41.

When voltage is applied between p-electrode 32 and n-electrode 33, the pn composition surface between the bottom of current block layer 48 and upper cladding layer 47 assume an opposite bias, and current does not flow in the region of current block layer 48. However, because the conductivity of current block layer 48 is reversed in current path 50 (the region where Zn has been scattered), making it p-conductive, the current from p-electrode 32 flows only in current path 50 and is conducted only to the portion of active layer 46 which is in line with current path 50, causing that region to luminesce. The light emitted by active layer 46 is conducted to the exterior through apertures 31 on window 28. Semiconductor luminous element D, then, has a design based on constricting the current. Furthermore, because current is supplied to active layer 46 not only via the inner edge of portion 32a, the portion of the electrode on the outside of window 28, but also via portion 32b, the part of the electrode within the window, there is no decrease in luminous output at the center of window 28. This design according to the invention, then, enhances the luminous efficiency of semiconductor luminous element D.

The peak reflectivity of multilayer reflective film layer 44 in this embodiment is 800 nm at vertical incidence. However, at an angle of incidence of 20°, the light must pass through a greater thickness of layer 44, and the wavelength of peak reflectivity becomes 850 nm, that of the emitted light. In other words, this design according to the invention produces a higher reflectivity for beams which strike obliquely. The component of the light emitted by active layer 46 in a downward direction which strikes multilayer reflective film 44 obliquely is efficiently reflected by that film and conducted through window 28 to the exterior, thus enhancing luminous efficiency.

AlGaAs layers 42 in multilayer reflective film 44 should have a thickness 1/(4n₁) that of the wavelength λ₀ of the emitted light (850 nm). AlAs layers 43 should have a thickness 1/(4n₂) that of the wavelength λ₀ of the emitted light. This being the case, the component of the light emitted by active layer 46 toward GaAs substrate 41 which strikes reflective film 44 vertically will be efficiently reflected by that film and conducted through window 28 to the exterior.

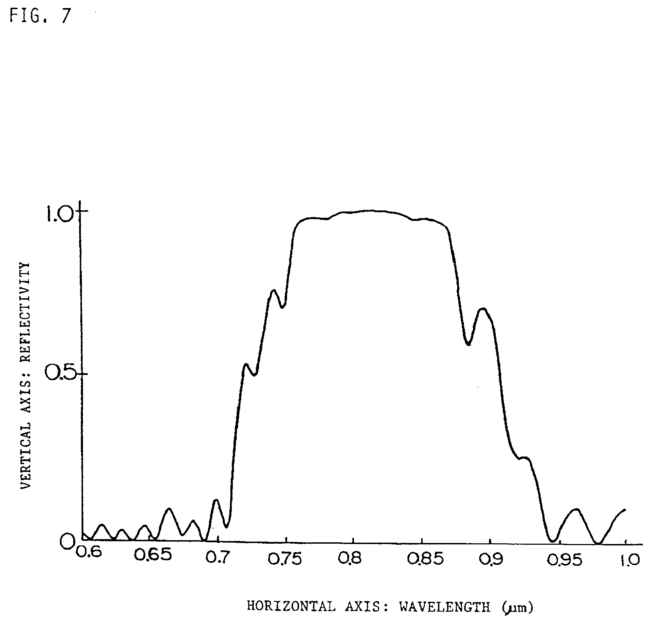

Multilayer reflective film layer 44 may be formed as follows. For example, it should have ten pairs of an AlGaAs layer with a thickness 1/(4n₁) and a central wavelength of 770 nm, and an AlAs layer with a thickness 1/(4n₂) and a central wavelength of 770 nm. It should have ten pairs of an AlGaAs layer with a thickness of 1/(4n₁) and a central wavelength of 810 nm, and an AlAs layer with a thickness 1/(4n₂) and a central wavelength of 810 nm. It should have ten pairs of an AlGaAs layer 42 with a thickness 1/(4n₁) and a central wavelength of 850 nm and an AlAs layer 43 with a thickness 1/(4n₂) and a central wavelength of 850 nm. Ten sets of each pair should be stacked in order to produce a total of 30 pairs, thus yielding a multilayer reflective film 44 with various central wavelengths. The reflective spectrum obtained by using multilayer reflective film layer 44 is shown in Figure 7. The reflectivity is high for a wide region of wavelengths shorter than λ₀, that of the emitted light (= 850 nm). Light emitted by active layer 46 in the direction of GaAs substrate 41 which strikes multilayer reflective film layer 44 at various angles is reflected efficiently, and luminous efficiency is enhanced.

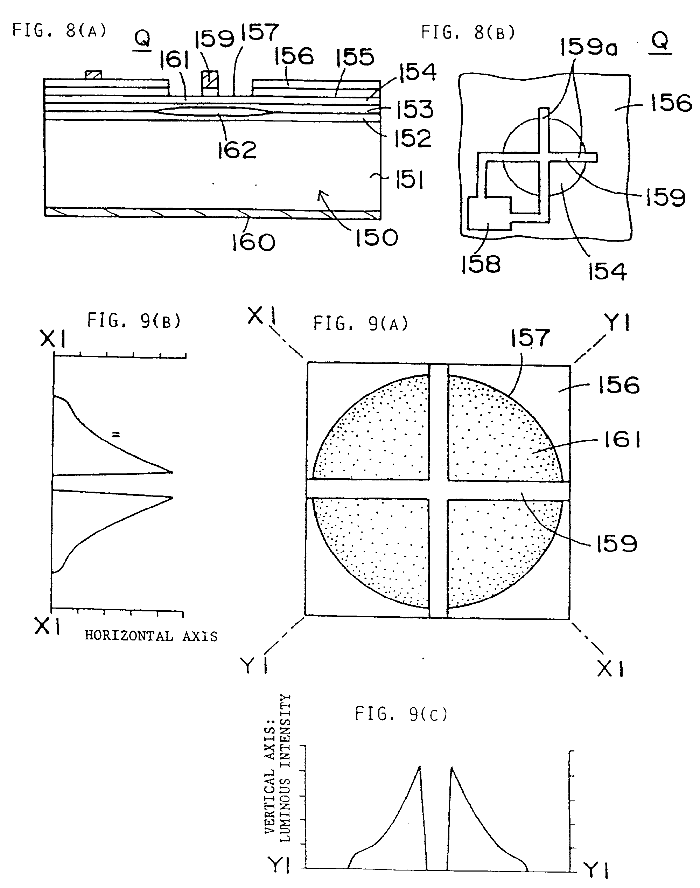

Figures 8 (a) and (b) show a cross section and a plan view of semiconductor luminous element Q, according to another embodiment of the invention. Luminous element Q is formed as follows. Lower cladding layer 152; active layer 153, which emits light; upper cladding layer 154; and cap layer 155 are epitaxially grown in that order on semiconductor substrate 151. Insulation layer 156 is formed on top of the cap layer to constrain the current. An aperture is created in insulation layer 156 to produce effective luminous region 157. Electrode pad 158 and surface electrode 159 are formed on the upper surface of semiconductor chip 150. Electrode pad 158 is formed on insulation layer 156. Two narrow bands of electrode (159a) extend from pad 158, traversing the upper surface of cap layer 155 over luminous region 157 in the shape of a cross to form surface electrode 159. Electrode 160 is formed on the lower surface of semiconductor substrate 151. When both front and back electrodes 159 and 160 have been formed, the portion of cap layer 155 which covers luminous region 157 is etched away to expose upper cladding layer 154.

In semiconductor luminous element Q, the area outside luminous region 157 is insulated by insulation layer 156, so current can flow only through luminous region 157. This design too, then, features a constricted current flow. Current is delivered to active layer 153 via current path 161, which corresponds to luminous region 157. If insulation layer 156 is transparent, light will also be emitted from the region surrounding the aperture in insulation layer 156. However, luminous region 161 is directly below the aperture in insulation layer 156, so most of the light will be emitted through the aperture. The area defined by the aperture constitutes the effective luminous region. Current is delivered to active layer 153 from surface electrode 159, which crisscrosses luminous region 157. Thus there is no drop in luminous output at the center of luminous region 157, and the luminous efficiency of semiconductor luminous element Q is enhanced. In contrast to the other embodiments which have been discussed, luminous element Q does not have a surface electrode 159 along most of the periphery of luminous region 157. As a result, very little current is delivered from the area peripheral to luminous region 157. This has the effect of concentrating the current in the center of luminous region 157 and increasing the quantity of current delivered to the center of that region. Current is supplied without limit to the entirety of luminous region 162, thereby preventing a ring-shaped pattern of emission. The diameter of the luminous region can be reduced and the luminous efficiency increased.

Figure 9 (a) shows a close-up view of luminous region 157 on semiconductor luminous element Q. (The density of the black dots shows how dark the area is; this will be true in subsequent illustrations as well.) Figures 9 (b) and (c) show the distribution of luminous intensity along line X₁-X₁ and line Y₁-Y₁. Because of the electrode pattern, the pattern of emission when viewed microscopically will appear cruciform. However, the center will have greater luminance and be brighter than the periphery. An annular emission pattern is avoided, and the diameter of the luminous area can be decreased.

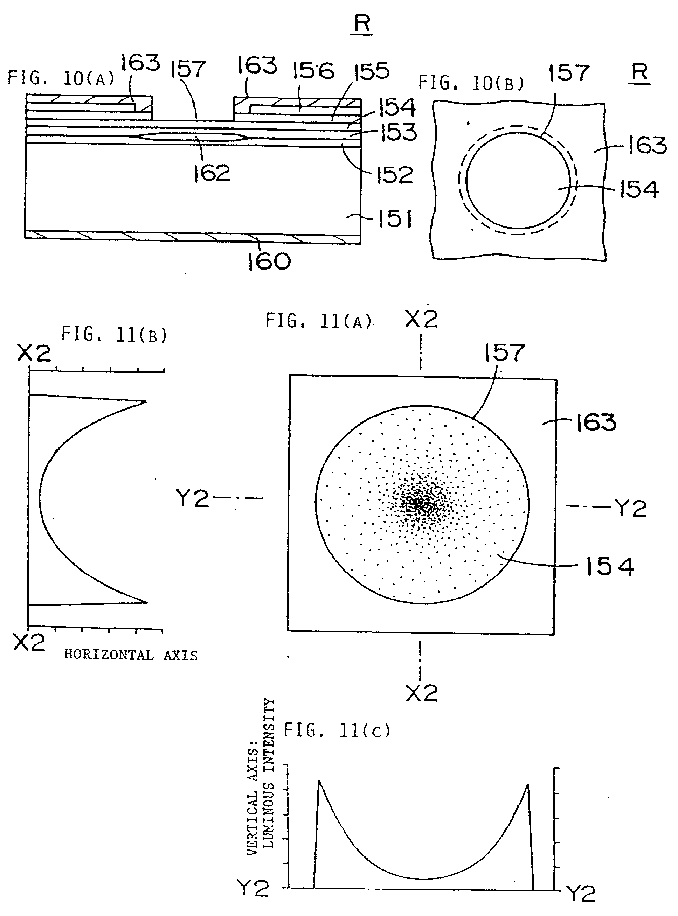

By way of contrast, related art semiconductor luminous element R, is pictured in Figures 10 (a) and (b). Luminous region 157 has been created by removing a portion of cap layer 155 and insulation layer 156. Surface electrode 163, which covers the entire surface of layer 156, is brought in contact with cap layer 155 on the periphery of luminous region 157. The dominant current is supplied via the edge of luminous region 157. For this reason, luminous element R has an emission pattern in the vicinity of luminous region 157 which resembles that in Figure 11 (a). The intensity distribution for Figure 11 (a) along lines X₂-X₂ and Y₂-Y₂ is shown in Figures 11 (b) and (c). Luminous element R, then, has a low luminous intensity in the center of the luminous region, resulting in a ring-shaped pattern of emission.

Where a luminous element is to be used in an optical device, it is desirable that a microscopic view of the luminous field should disclose either a uniformly luminous surface or one whose greatest luminous intensity is in the center. Comparing the emission patterns of luminous element Q, the element designed according to the invention (Figure 8), and luminous element R, the related art element (Figure 10), one can see that luminous element Q, an embodiment according to the invention, is better suited for use in an optical device. When the element is used in a luminous device, it might be problematical that no light radiates from the regions covered by surface electrode 159. However, this problem can be obviated by making the bands of electrode 159 extremely narrow. When luminous efficiency was calculated using a light-emitting diode of the AlGaInP family with a luminous region 50 µm in diameter and an electrode 4 µm wide, luminous element Q according to the invention was found to have a luminous efficiency 85% greater than that of prior art luminous element R. The result of this calculation was in conformity with experimental results, which confirmed that luminous element Q had greater luminous efficiency and superior luminous output.

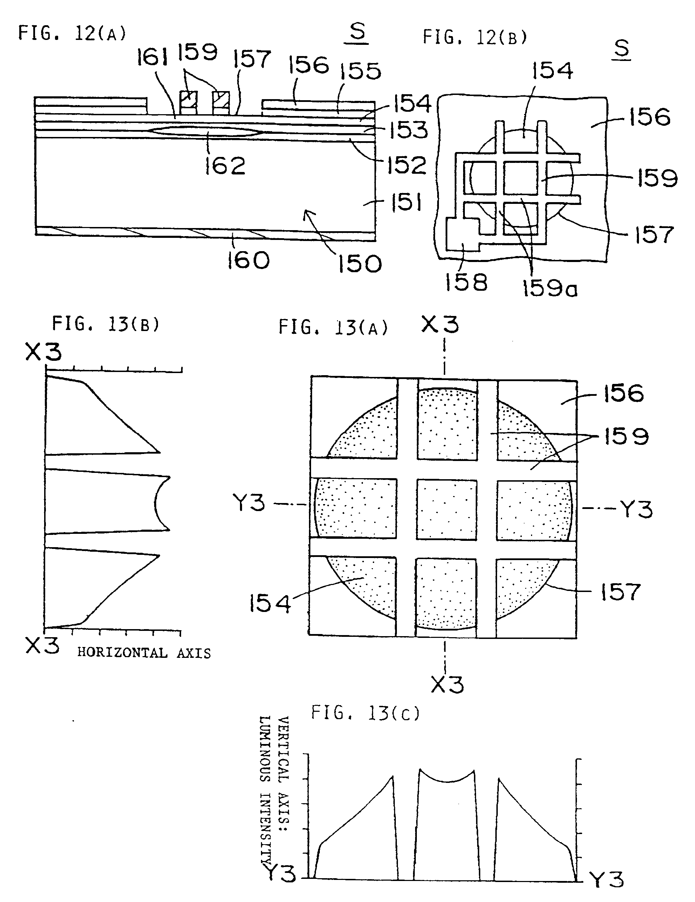

Figures 12 (a) and (b) show a cross section of semiconductor luminous element S, another embodiment according to the invention, and a plan view of its luminous region 157. In semiconductor luminous element S, surface electrode 159 extends from electrode pad 158 on the upper surface of cap layer 155 in luminous region 157. Electrode 159 has the form of parallel crosses. Figure 13 (a) shows a close-up view of luminous region 157 on semiconductor luminous element S. Figures 13 (b) and (c) show the distribution of luminous intensity along line X₃-X₃ and line Y₃-Y₃. As is clearly shown in these diagrams, in luminous element S the light emitted from the center of luminous region 157 is not obstructed by surface electrode 159. Thus light of a high intensity is emitted from the center of luminous region 157, and the luminous intensity overall is virtually uniform.

In luminous element S, current is supplied efficiently through four narrow bands of electrode (159a) which span luminous region 157, and only through those bands. In the close-up views one can be see that the area of the electrode which is in contact with luminous region 157 in element S is larger than that in prior art element R. This allows more current to flow and increases the maximum luminous output. And the center of the luminous region, which in the prior art element did not contribute to luminance, now emits light; so the luminous efficiency of element S is also greater than that of element R. If luminous efficiency is modeled using the same method as before, it is found that the efficiency of semiconductor luminous element S is 51% greater and the maximum luminous output 23% greater than that of the prior art luminous element. This conforms well with experimental results.

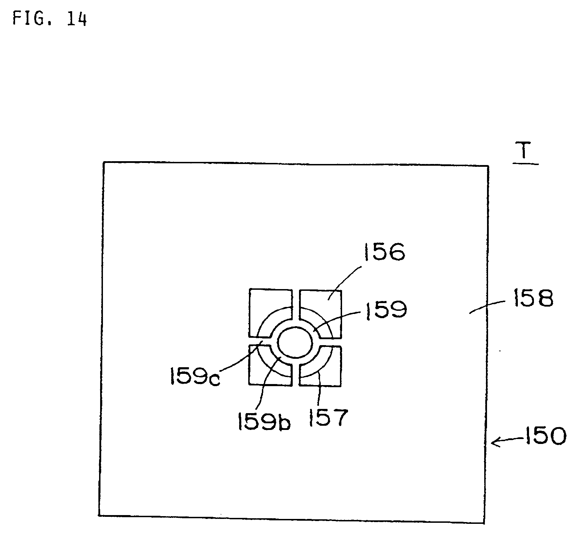

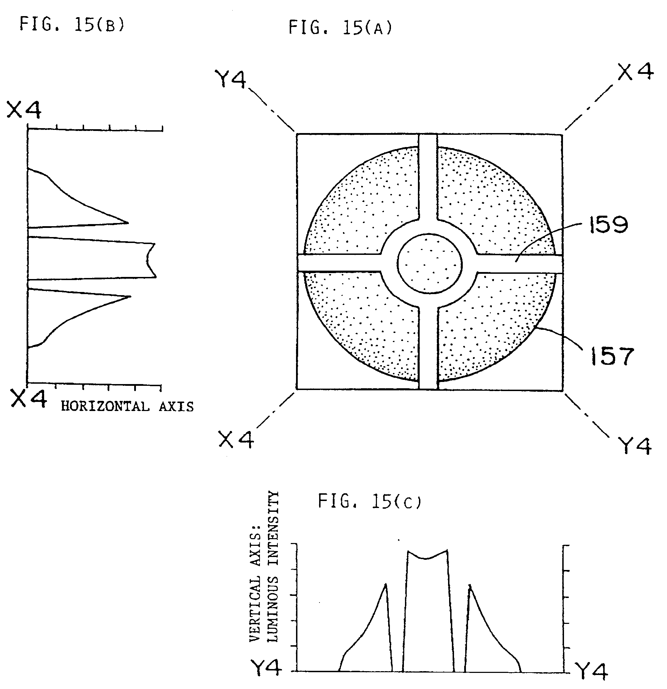

Figure 14 is a plan view of semiconductor luminous element T, another embodiment according to the invention. In luminous element T, electrode pad 158 takes the form of a frame surrounding insulation layer 156, which is formed on the upper surface of semiconductor chip 150. Thus the electrode pad is removed from luminous region 157. Surface electrode 159 consists of annular portion 159b, which is formed within luminous region 157, and thin bands 159c, which extend from electrode pad 158 to annular portion 159b. This configuration minimizes the quantity of current delivered via the periphery of luminous region 157 and maximizes the quantity delivered from within the luminous region. There is no electrode in the center of luminous region 157, so the light emitted there is not obstructed. Figure 15 (a) shows a close-up view of luminous region 157 on semiconductor luminous element T. Figures 15 (b) and (c) show the distribution of luminous intensity along line X₄-X₄ and line Y₄-Y₄. As shown in these diagrams, in luminous element T the light emitted from the center of luminous region 157 (and in particular, the portion within annular portion 159b) is of a high intensity. If luminous element T were to be used in an optical device, it would be desirable that the central portion of luminous region 157 emit a more intense light, as this would maximize the coupling efficiency of the lens and the luminous element.

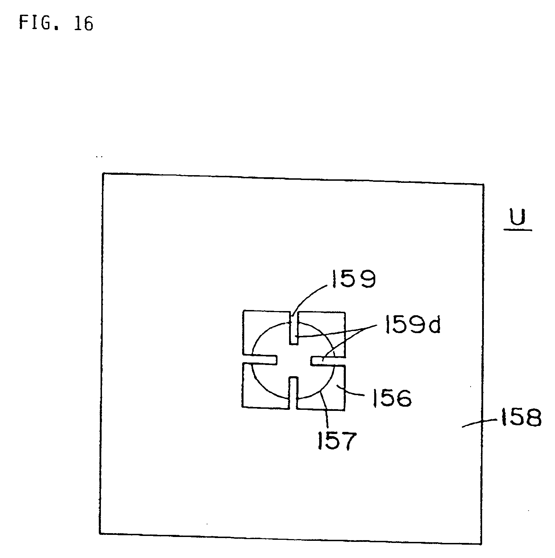

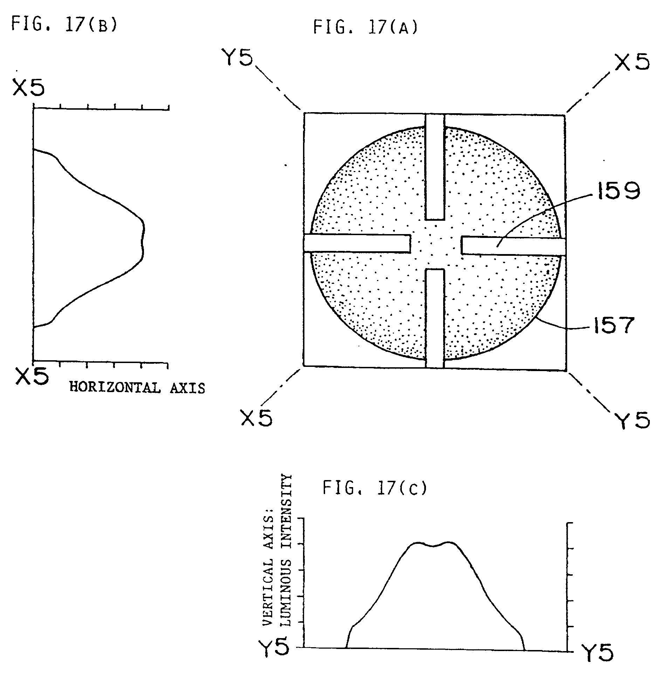

Figure 16 shows a cross section and a plan view of semiconductor luminous element U, another embodiment according to the invention. In luminous element U, electrode pad 158 surrounds insulation layer 156 at a slight remove from it. Surface electrode 159 has four thin bands 159d, which extend from electrode pad 158 toward the center of luminous region 157 but do not go all the way to the center. This configuration minimizes the quantity of current delivered via the periphery of luminous region 157 and maximizes the quantity delivered from within the luminous region. There is no electrode in the center of luminous region 157, so the light emitted there is not obstructed. Figure 17 (a) shows a close-up view of luminous region 157 on semiconductor luminous element U. Figures 17 (b) and (c) show the distribution of luminous intensity along line X₅-X₅ and line Y₅-Y₅ in Figure 17 (a). As shown in these diagrams, in luminous element U the light emitted from the center of luminous region 157 is of a high intensity, and the intensity distribution along lines X₅-X₅ and Y₅-Y₅ is gentle sloped.

In this embodiment according to the invention, luminous region 157 is not partitioned by surface electrode 159. The most convenient way to form electrode 159 is the lift-off method. The portion of the electrode film which needs to be removed is a single piece, and it can be lifted off easily because it is relatively large. When forming an electrode pattern like that shown in Figure 16, then, the ease of the lift-off method provides an advantage in the production of the luminous element.

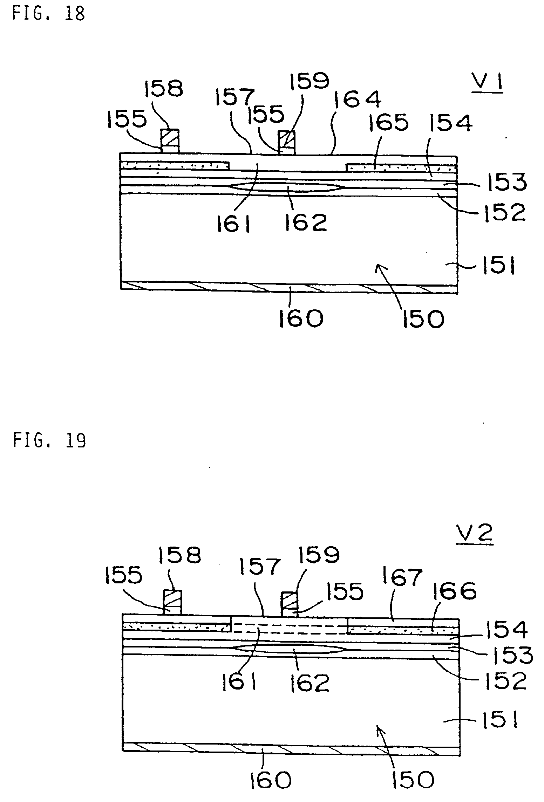

Figures 8 through 17 show electrode patterns intended to increase the quantity of current delivered to the interior of luminous region 157. Figures 18 through 21 show several additional structures for the semiconductor chip 150 on which these patterns can be formed.

In semiconductor luminous element V₁, which is pictured in Figure 18, the current is constrained by the following design. Conductive layer 164 is formed between upper cladding layer 154 and cap layer 155. High resistance layer 165 is created by injecting ions into all but the central portion of layer 164. The region where layer 165 has not been formed becomes luminous region 157. Electrode pad 158 and surface electrode 159 are formed on the upper surface of cap layer 155. All portions of cap layer 155 except for electrode pad 158 and surface electrode 159 are etched away. In a semiconductor chip configured like chip 150, the current path is quite close to luminous region 162. This increases the effectiveness of the current path and improves luminous efficiency.

In semiconductor luminous element V₂, shown in Figure 19, current barrier layer 166, which has conductivity opposite that of upper cladding layer 154, is formed on top of that cladding layer. Conductive layer 167, whose conductivity is the same as that of layer 154, is formed on top of barrier layer 166, and cap layer 155 is formed on top of that. The conductivity of barrier layer 166 is reversed in the region which is to become current path 161 and luminous region 157 by scattering impurities with the same conductivity as upper cladding layer 154 in that region. Current is then delivered to active layer 153 only through current path 161, which now has conductivity opposite that of barrier layer 166. Thus a constraint has been placed on the current path. In a semiconductor chip configured like chip 150, the current path is quite close to luminous region 162. This increases the effectiveness of the current path and improves luminous efficiency.

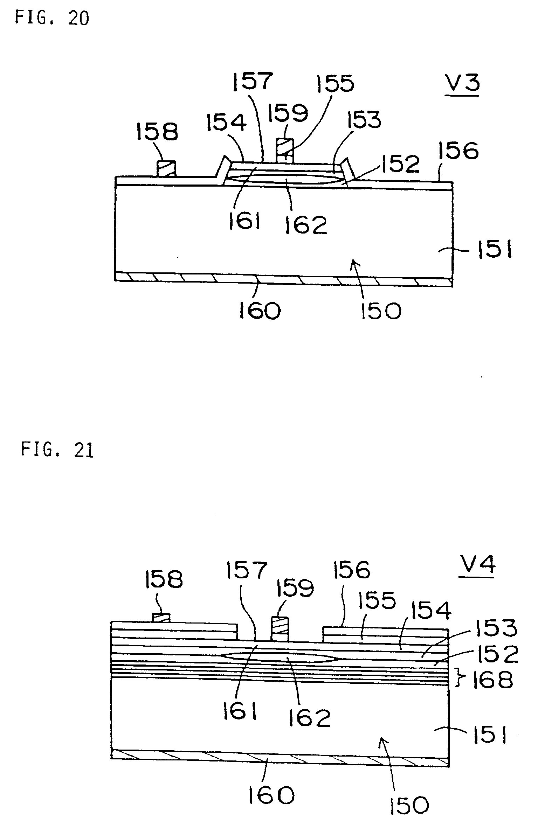

In semiconductor luminous element V₃, pictured in Figure 20, the current constriction is created by etching away all but the central portions of lower cladding layer 152, active layer 153 and upper cladding layer 154 to form a mesa. The effectiveness of this type of current constriction is very high in a chip like semiconductor chip 150, and luminous efficiency is also high.

In semiconductor luminous element V₄, which is pictured in Figure 21, a multilayer reflective film 168 is formed between semiconductor substrate 151 and lower cladding layer 152. Multilayer reflective film 168 would generally be constructed by stacking alternately materials with refractive indices n₁ and n₂ to create films of thickness β₁, which is equal to λ₀/(4n₁), and thickness β₂, which is equal to λ₀/(4n₂). (λ₀ is the central wavelength of the light emitted by active layer 153.) Light of a wavelength such that 4β₁ = 4β₂ = λ₀, the wavelength of the materials constituting reflective film 168, will be reflected most intensely. Thus the light emitted by luminous region 162 of active layer 153 toward semiconductor substrate 151 is reflected by multilayer reflective film 168 and radiated to the exterior through luminous region 157. This scheme increases the luminous efficiency and boosts the luminous output of the element.

Because luminous region 162 emits light over a wide region of wavelength components, a wide region of wavelengths is reflected by multilayer reflective film 168. Each film comprising multilayer reflective film 168 should have a different thickness, as β₁₁, β₁₂, β₁₃, ...; β₂₁, β₂₂, β₂₃, ..., so that light of wavelengths β₁₁, β₁₂, β₁₃, ...; β₂₁, β₂₂, β₂₃, ... will be reflected most intensely. The fact that light is reflected over a wide region of wavelengths is advantageous in that it enhances luminous efficiency.

In every embodiment shown from Figure 8 on, it is desirable to maximize the thickness of the film (i.e., the aggregate thickness of each individual layer) between luminous region 162 and surface electrode 159. Maximizing the film thickness increases the component of the light which travels in a sideward direction between surface electrode 159, which delivers the current, and luminous layer 162. This will result in the intensity of the light being more nearly uniform between the surface and the interior of the luminous element, which will make it more suitable for use in an optical device.

The invention is not confined to light emitting diodes, but can also be applied to surface-emitting semiconductor laser elements. The constricted current path which is a central feature according to the invention can also be fashioned in the layers below the active layer.

When a semiconductor luminous element with a microscopic luminous area incorporating the invention is used in a luminous device, a photocoupler, an optical detector, an optical data processor, or a photoemissive device, its collimation length and the quality of its focus ensure that it will significantly enhance the capabilities of the device (such as its resolution). Examples in which the aforesaid semiconductor luminous element has been applied are discussed further herein.

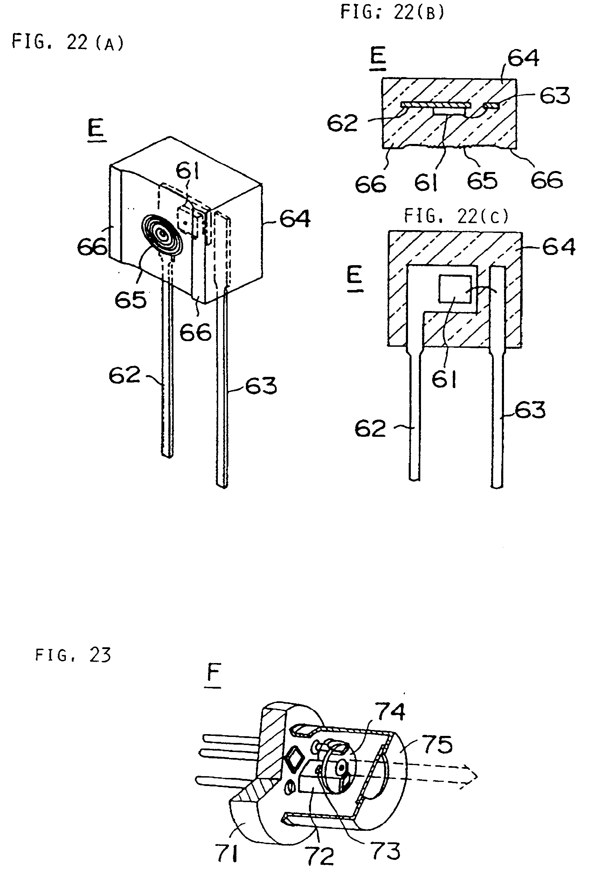

Figures 22 (a), (b) and (c) show photoemissive device E, a luminous device which shall now be discussed. In photoemissive device E, semiconductor luminous element 61 is die-bonded to the top of lead frame 62 and wire-bonded to the top of lead frame 63. It is sealed in resin 64, a clear epoxy resin or some similar substance, in a predetermined shape, via low-voltage injection molding, to produce a device in the shape of a square block. On the front of resin seal 64 is formed a flat Fresnel lens 65 which consists of a number of concentric annular lens segments. On either side of the front of the epoxy seal protrude flanges 66, which are the same height as or slightly higher than Fresnel lens 65. These flanges protect Fresnel lens 65.

In photoemissive device E, semiconductor luminous element 61 has a high luminous efficiency combined with a microscopic luminous region. The directivity of the light is constrained by flat Fresnel lens 65. As a result, the output is high and a narrow beam can be achieved over a long distance. If, for example, the focal distance f of Fresnel lens 65 is 4.5 mm, the diameter of the lens 3.5 mm, and the diameter of the window in luminous element 61 is 20 µm, the diameter of the beam at a distance of 1m will be approximately 4 mm. Light emitting diodes generally used in the past (that is, diodes with a luminous surface approximately 350 µm square) will produce a beam 70 mm in diameter at that distance. Thus using a luminous element 61 designed according to the invention will yield a tremendous advantage in the production of a photoemissive device E.

A photoemissive device F of the related art is pictured in Figure 23. Semiconductor laser element 73 and flat Fresnel lens 74 are mounted on heatsink 72, which protrudes from stem 71. These are covered by metal cap 75 to produce a can-type seal. Photoemissive device E has a vastly simpler configuration than device F, can be produced at a lower cost, and requires a smaller volume of space.

Disclosed is a device which emits parallel light beams with narrow directivity. However, by adjusting the parameters of flat Fresnel lens 65, one could produce a device which would emit a condensed or polarized beam.

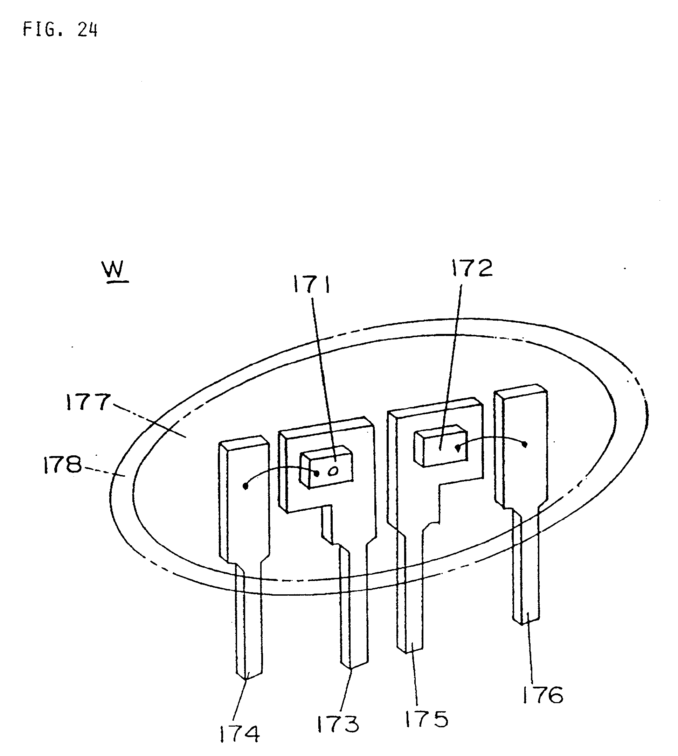

Figure 24 shows a photocoupler. More specifically, Figure 24 shows photocoupler W, whose components are arrayed on a single surface, and which employs as a light source a semiconductor luminous device 171 according to the invention. In photocoupler W, semiconductor luminous element 171 and semiconductor photodetector 172 are die-bonded to lead frames 173 and 175, respectively; and they are wire-bonded to lead frames 174 and 176, respectively. The entire structure is then sealed in a sheet of clear epoxy resin 177. Reflective film 178 is formed on the front of clear epoxy resin sheet 177. Generally, photodetectors have their luminous element and their photodetector facing each other. Flat photocoupler W is distinguished by the fact that luminous element 171 and photodetector 172 are arrayed on the same plane.

This type of flat photocoupler W can be molded very easily, so it is simple to produce. However, it cannot produce light of a very high intensity, nor is it capable of a high coupling efficiency. If a luminous element 171 according to the invention is used in place of a conventional luminous element in photocoupler W, a higher luminous output can be achieved, and a higher coupling efficiency will result. If clear epoxy seal 177 is given the form of an ellipsoid, and luminous element 171 and photodetector 172 are placed at its focal points, an efficient coupling can be achieved. If the luminous element 171 according to the invention is used, the small diameter of the luminous region will enable an even higher coupling efficiency to be attained.

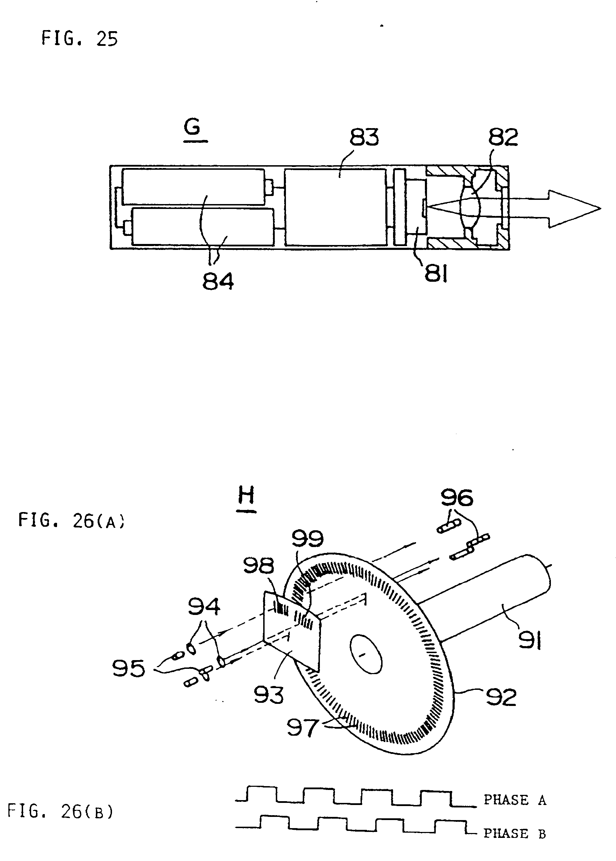

Figure 25 shows hand-held pointer (photoemissive device) G, a device used to indicate the position of an image on a screen. Pointer G includes LED (light emitting diode) 81, designed according to the invention; collimating lens 82; movement circuit 83; and batteries 84. The light emitted by semiconductor luminous element 81 is collimated by lens 82 and projected onto the screen to indicate the desired location with a spot of light.

Most pointers now available use semiconductor laser elements. Since these emit laser light, they pose a potential hazard to the eyes of everyone in the vicinity. Because of the danger involved, lasers are sometimes subject to problematical regulations. One solution to this difficulty would be to make an LED pointer using a luminous diode. However, existing conventional surface-emitting LEDs (the diameter of whose luminous area is 400 µm) have a focal distance of 10 mm. If the light is collimated by a lens 4mm in diameter, the beam striking a screen five meters away will have a diameter of 200 mm, which means it will be so large as to be virtually invisible.

In contrast, a pointer G using an LED 81 according to the invention, with a luminous diameter of 10 µm, a focal distance of 10 mm, and the same 4 mm-diameter collimating lens 82, will produce a beam 5 mm in diameter if the screen is five meters away. This size of spot could easily be seen. Because the LED 81 of the invention has greater luminous output and directivity, it can be used in the production of a safe pointer G with a spot that is easy to see.

Figure 26 (a) shows a perspective view of transmitting-type optical rotary encoder H, which uses semiconductor luminous element 95 according to the invention. Rotary encoder H includes rotary disk 92, which is mounted on rotary shaft 91; fixed plate 93, which is in line with the periphery of rotary disk 92; lenses 94, which face each other between rotary disk 92 and fixed plate 93; semiconductor luminous elements 95, designed according to the invention; and photodetectors 96. All around the outer edge of rotary disk 92 are slits 97, provided at intervals of 1 mm. Fixed plate 93 has a set of slits 98 in track A and another set, 99, in track B, both at intervals of 1 mm.

The light emitted by semiconductor luminous elements 95 is collimated by lenses 94 and divided by slits 98 and 99 on fixed plate 93. The light passes through slits 97 on rotary disk 92 and is detected by photodetectors 96. Slits 98 on track A of fixed plate 93 and slits 99 on track B are phase-shifted by 90° with respect to each other. When the phase A signal and the phase B signal are both on (the state of the photodetectors), one unit (one slit) of the scale is counted. In this way the scale can be read. Figure 26 (b) shows how the direction of rotation can be discriminated by determining whether the signal is on after phase A or after phase B.

If a conventional surface-emitting semiconductor luminous element (with a luminous diameter of 400 µm) is used in this type of rotary encoder, with a focal distance of 10 mm and a collimating lens 4mm in diameter, the poor collimation will result in the beam on the rotary disk having a diameter approximately 40 µm wider than the slits on the fixed plate. With a scale greater than 600DPI (at a pitch of 40 µm), the beam will have a diameter greater than the width of the slits, making the scale impossible to read. This type of luminous element, then, cannot be used in a high-resolution encoder.

In contrast to this, consider a rotary encoder H using semiconductor luminous element 95 designed according to the invention. The luminous region of element 95 has a diameter of less than 10 µm. At a focal distance of 10 mm and using the same collimating lens 94 with a diameter of 4 mm, the beam striking rotary disk 92 will have a diameter only 0.5 µm greater than the width of the slits on fixed plate 93. High resolution can be achieved, and a scale greater than 600DPI (at a pitch of 40 µm) can be read. If the semiconductor luminous element 95 of the invention is used in rotary encoder H, then, the resolution of the encoder will be improved without the addition of any special optical system.

The above embodiment discloses a rotary encoder. However, the same effect can be achieved by using the semiconductor luminous element of the invention in a linear encoder.

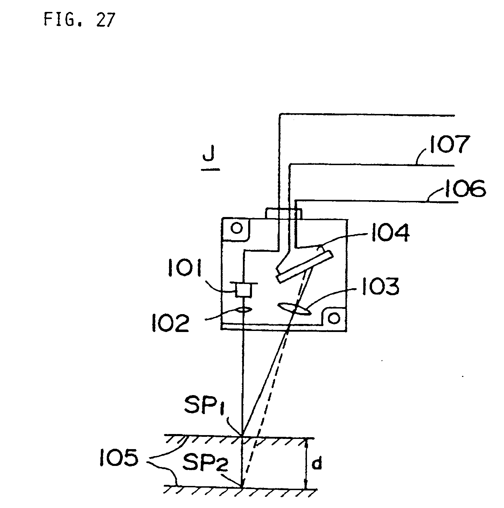

Figure 27 shows the configuration of optical distance sensor J, which uses semiconductor luminous element 101, designed according to the invention. Distance sensor J comprises a photoemission unit, including luminous element 101 according to the invention and collimating lens 102; and a photodetection unit, having lens 103 and position detector element 104.

Figure 27 illustrates a situation in which the said distance sensor J calculates the distance d between two surfaces on object 105. The light emitted by semiconductor luminous element 101 is arranged into parallel beams by collimating lens 102 and projected onto object 105 as beam spots SP₁ and SP₂. The images of the reflected beam spots are formed on position detector element 104. The positions of these images are detected via the difference between the signals obtained on signal lines 106 and 107. Once the discrepancy between the two positions has been found, the distance d can be calculated using the principle of triangulation.

Semiconductor luminous element 101, following the invention, has a high output and a microscopic aperture which circumscribes the luminous region. With an ordinary luminous diode, that is, one whose luminous surface is approximately 350 µm square, it is difficult to detect an object over a long distance or with great accuracy. Using a luminous element 101 according to the invention in distance sensor J, objects can be detected at a great distance. Moreover, because the beam spot has a small diameter, the resolution of the detector is enhanced. A laser diode can be used to detect objects at a distance with great accuracy; however, the use of a laser beam leads to safety problems. According to the invention, a light emitting diode like luminous element 101 can be produced which has a high output and a luminous area of microscopic diameter. Such a diode would enable detection over a long distance, its beam spot would have a small diameter, its resolution would be high, and it would pose no problems with respect to human safety.

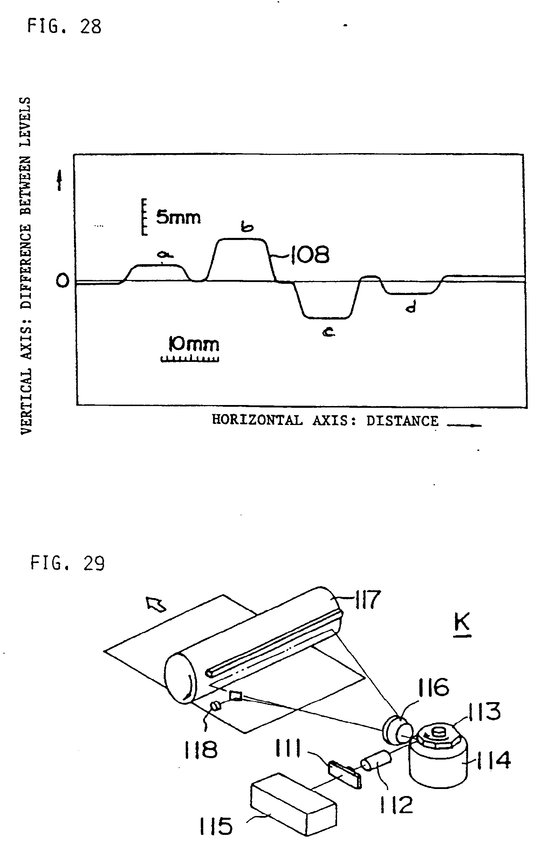

Figure 28 shows the result of measuring level differences d using the aforesaid distance sensor J. The object in question is placed 10cm away from sensor J. It has segments which protrude upward to heights of 2 mm and 5 mm, and depressions with depths of 2 mm and 5 mm. Characteristic curve 108 corresponds to level differences d. a represents the location of a 2 mm protrusion, b that of a 5 mm protrusion, c that of a 5 mm depression, and d that of a 2 mm depression.

Figure 29 is a perspective view of a laser beam printer K, which uses semiconductor laser element 111, designed according to the invention. Printer K includes semiconductor laser element 111; collimating lens 112, on the emitting side; rotating multifaceted mirror (polygonal mirror) 113; scanner motor 114, which rotates mirror 113 in a given direction at a fixed speed; scanner controller 115; condenser lens 116; photosensitive drum 117; and photosensor 118, for horizontal synchronization.

The light emitted by semiconductor laser 111 passes through and is collimated by collimating lens 112. It is reflected by rotating multifaceted mirror 113 and scanned in a horizontal direction. The light is condensed on photosensitive drum 117 by condenser lens 116, and a latent image is produced on that drum.

If a prior art LED (with luminous diameter of 400 µm) is used in this type of laser beam printer, and the light is condensed on a photosensitive drum 150 mm away by a condenser lens with a focal distance of 15 mm, the poor quality of the beam condensing will yield a beam 4.8 mm in diameter on the surface of the drum. such a beam will not meet a print density specification of 400DPI.

In laser beam printer K, which uses a semiconductor laser element 111 according to the invention, the luminous diameter is only 5 µm. When the beam is condensed under identical conditions, its diameter on the drum will be under 60 µm, and a specification of 400DPI can be met.

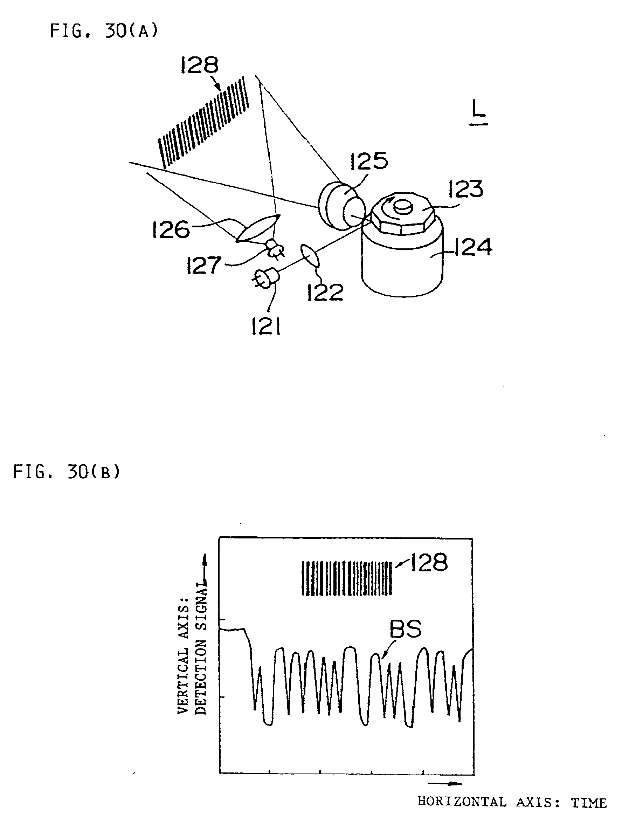

Figure 30 (a) is a perspective view of bar code reader L, which uses a semiconductor luminous element 121 designed according to the invention. Bar code reader L includes semiconductor luminous element 121; condenser lens 122, on the emitting side; rotating multifaceted mirror 123; scanner motor 124, which rotates mirror 123 in a given direction at a fixed speed; lens 125, which produces a scan at a uniform speed; condenser lens 126, on the detecting side; and photodetector 127.

The light emitted by semiconductor luminous element 121 passes through condenser lens 122, is reflected by rotating multifaceted mirror 123, and is scanned in a horizontal direction. The scanning speed is made uniform by lens 125, and the beam is condensed on and scanned over bar code 128. The light reflected by bar code 128 is condensed on photodetector 127 by condenser lens 126. The bar code is detected, and bar code signal BS is obtained. In bar code reader L, lens 125 ensures that the bar code will be scanned at a uniform speed. Figure 30 (b) shows the signal BS corresponding to bar code 128, with the elapsed time on the horizontal axis and the detected signal (bar code signal BS) on the vertical axis.

If a conventional surface-emitting LED (with a luminous diameter of 400 µm) is used in this type of bar code reader, and the beam is condensed on a bar code 250 mm away by a condenser lens with a focal distance of 15 mm, the poor quality of the beam condensing will yield a beam more than 6.7 mm in diameter on the bar code. With such a beam, it will be utterly impossible to read the code (which generally has a minimum width of 0.2 mm).

If semiconductor luminous element 121, designed according to the invention, is used in bar code reader L, the diameter of the luminous region will be less than 10 µm. If the beam is condensed under the same conditions, the diameter of the beam striking bar code 128 will be less than that of the narrowest line in the code (less than 0.2 mm), so the code can be read.

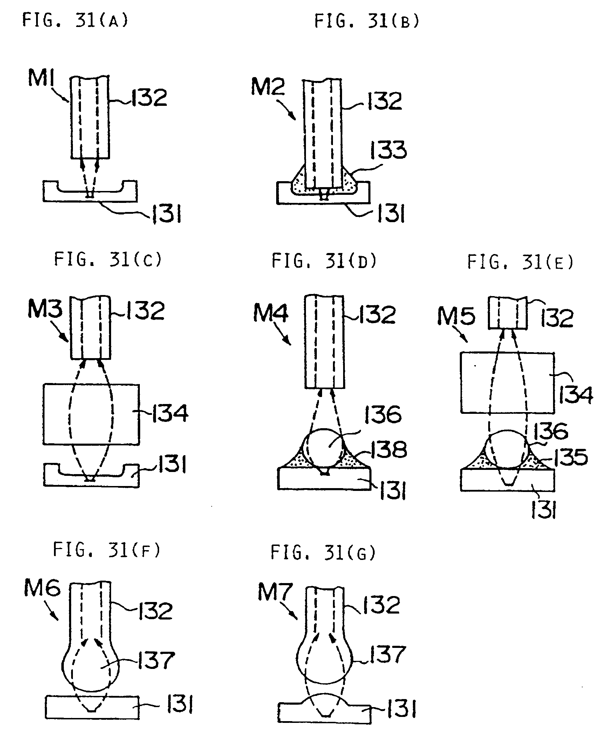

Figures 31 (a) through (g) are simplified drawings of optical fiber modules M₁ through M₇, which include a semiconductor luminous element 131 designed according to the invention and an optical fiber 32. Figure 31 (a) shows optical fiber module M₁, a direct-coupling type module in which the end of optical fiber 132 faces the luminous region of semiconductor luminous element 131. The light emitted by element 131 is conducted from the end of fiber 132 into its core and transmitted through the interior of the fiber. Figure 31 (b) shows optical fiber module M₂, a direct-coupling type module in which semiconductor luminous element 131 is brought quite close to the end of optical fiber 132. The space between element 131 and fiber 132 is filled with optical resin 133. Figures 31 (c), (d) and (e) show optical fiber modules M₃ through M₅, all of which feature the use of a separate lens. To focus the beam, these modules have an optical system between semiconductor luminous element 131 and the end of optical fiber 132. The light emitted by semiconductor luminous element 131 is focused by the optical system so that it can be conducted efficiently into optical fiber 132. Optical fiber module M₃, pictured in Figure 31 (c), uses rod lens 134 to focus the beam; module M₄, pictured in Figure 31 (d), uses spherical lens 136, which is fixed in place by resin 135; and module M₅, pictured in Figure 31 (e), uses both rod lens 134 and spherical lens 136. Optical fiber modules M₆ and M₇, pictured in Figures 31 (f) and (g), have an optical fiber 132 with a spherical segment 137, which functions as a lens, on its end. Optical fiber 132 faces semiconductor luminous element 131.

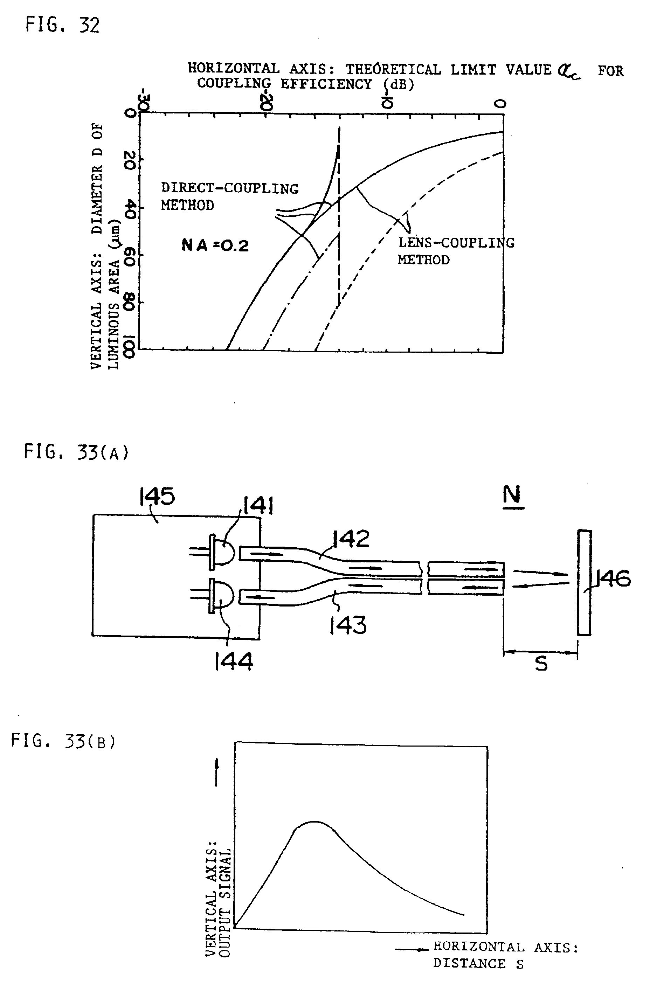

In this type of optical fiber module, the coupling efficiency of the semiconductor luminous element and the optical fiber is highly dependent on the diameter of the luminous region of that element. Figure 32 is a graph showing the theoretical limit value α_{c} for coupling efficiency in several types of optical fiber modules of both the direct coupling type and the lens-coupling type. (Hirokatsu Kometsu, *Hikari Tsushin Soshi Kogaku (The* *Engineering of Optical Communication Elements)*, Kogaku Tosho (optical Library)) As can be understood from the graph, it is generally true that the smaller the diameter D_{L} of the luminous area of a semiconductor luminous element, the higher the coupling efficiency. Thus decreasing the luminous diameter of an element would be an extremely effective way to increase the coupling efficiency of an optical fiber module.

In a semiconductor luminous element using a conventional LED, however, decreasing the luminous diameter would increase the resistance of the element. Heat production would vastly increase, and a high luminous output would not result.

With a semiconductor luminous element (more specifically, an LED) 131 with a luminous area of small diameter, according to the invention, the increase in the resistance of the element is low even with the small diameter, so the drop in luminous output can be minimized. A high coupling efficiency can be achieved without incurring a drop in luminous output. The semiconductor luminous element 131 of the invention uses a material in the AlGaInP family for active layer 46; so even though the minimum transmission loss of the plastic fiber is about 660 nm, a high luminous efficiency can be achieved. An optical fiber communication system which employs plastic fiber can have a high S-to-N ratio with low loss.

Figure 33 (a) is a simplified drawing of optical fiber-type sensor N, which uses semiconductor luminous element 141, designed according to the invention. Sensor N includes semiconductor luminous element 141; optical fiber 142, which emits light; optical fiber 143, which receives light; photodetector 144; and processor circuit 145.

The light emitted by semiconductor luminous element 141 is transmitted with low loss by optical fiber 142. The light exits from the end of fiber 142 and is projected onto object 146. The light reflected by object 146 enters optical fiber 143 and is detected by photodetector 144. The output signal representing the light detected by photodetector 144 varies with the distance S between the ends of optical fibers 142 and 143 and object 146 as in Figure 33 (b). From the output of the photodetector, one can determine the distance S of object 146. In this type of sensor, the distance at which the photodetector signal drops to the lowest level at which it can be detected is the longest possible detection distance. If a semiconductor luminous element 141 according to the invention is used, it will emit a beam with a microscopic diameter. The coupling efficiency of the element with optical fiber 142 will be high, so that a greater quantity of light will enter optical fiber 142. Even when the distance S to object 145 is long, a sufficient detection signal will be obtained. Thus the use of this luminous element will result in a longer potential detection distance.

As disclosed herein, the invention concerns a semiconductor luminous element with a microscopic luminous area. According to the invention, current is supplied to the luminous layer not only from an electrode which surrounds the window through which the light exits, but also from an electrode within the window. This insures that the region of the luminous layer which is in line with the window will luminesce uniformly. There will be essentially no drop in luminous output at the center of the window and a substantially uniform pattern of luminescence will be achieved. This results in an increase in luminous efficiency.

The surface area of the electrode is increased, so the forward voltage can be decreased. The saturation current for luminous output is raised, also resulting in an increase in total luminous output.

If a multilayer film consisting of films whose thickness is 1/(4n) the wavelength of the emitted light is formed on the side of the element opposite the window for the luminous layer, the light emitted by that layer in the direction opposite the window can be reflected and conducted to the exterior through the window. This will further enhance the luminous efficiency of the element.

If a multilayer film which contains films whose thickness is less than 1/(4n) the wavelength of the emitted light is formed on the side of the element opposite the window for the luminous layer, the light emitted by that layer obliquely in the direction opposite the window can also be reflected and conducted to the exterior through the window. This will further enhance the luminous efficiency of the element.

The semiconductor luminous element designed according to the invention has a microscopic luminous area and a high luminous output. If it is used in an optical detector or optical data processor, photoemissive device or optical fiber module, it will enable the production of an optical device with excellent optical properties such as high resolution.

In order to supply current to the entire luminous region, instead of forming an electrode which completely surrounds the upper surface of the luminous region, narrow bands of electrode are provided which extend from the periphery toward the center of the luminous region. This allows the entire luminous region to contribute to luminescence, which results in higher luminous efficiency. The shape of the electrode not only increases the luminous efficiency, but also enhances the maximum luminous output.

The light emitted directly below the electrode bands will not be radiated to the exterior. For this reason, when the electrode is formed, no portion of it should cover the center of the luminous region, so as to improve the coupling efficiency of the lens. This will make the element more suitable for use in an optical device.

An electrode of a shape which does not partition the luminous field will require a considerable time for the lift-off process when the electrode is formed. Generally, a constricted current path is created via an insulation layer. Such a path can also be created by forming a high-resistance layer in the element through ion injection; by scattering impurities in the region which is to become the path; or by etching the surface of the element. Any of these methods will yield a element with a higher luminous efficiency.

This type of semiconductor luminous element according to the invention has a small luminous area and a high luminous output. If used in an optical detector, it will enable the production of a highly accurate and safe detector which does not require the use of multiple optical systems. The same effect can be achieved if the element is used in an optical data processor. Use of this element in a photocoupler will contribute to high efficiency of conversion. In a luminous device, it will produce a device with a narrow beam and a high luminous output.

While several embodiments of the invention have been described, it will be understood that it is capable of further modifications, and this application is intended to cover any variations, uses, or adaptations of the invention, following in general the principles of the invention and including such departures from the present disclosure as to come within knowledge or customary practice in the art to which the invention pertains, and as may be applied to the essential features hereinbefore set forth and falling within the scope of the invention.

## Claims

1. A semiconductor luminous element comprising:
a luminous layer;
a first and second electrode to supply current to said luminous layer, said first electrode being furnished on a first side of said element;
a component furnished on at least said first side operative to confine to a specific region an effective luminous area from which light generated from said luminous layer is radiated to an exterior of said element; and
an extended electrode extending from at least said first electrode into said effective luminous area.

2. The semiconductor luminous element recited in claim 1, wherein said component operative to confine said effective luminous area is said first electrode having an opaque substance.

3. The semiconductor luminous element recited in claim 2, having a layer between said first and second electrodes, said layer defining a path for said current such that said current flows substantially directly below said aperture on said first electrode.

4. The semiconductor luminous element recited in claim 2, wherein said luminous element has a mesa.

5. The semiconductor luminous element recited in claim 1, wherein said component operative to confine said effective luminous area limits the path of said current in order to bound said luminous layer.

6. The semiconductor luminous element recited in claim 5, wherein said component comprises a layer which constricts flow of said current.

7. The semiconductor luminous element recited in claim 5, wherein said luminous element has a mesa, and said component comprises an insulation layer formed on an outer surface of sides of said mesa.

8. The semiconductor luminous element recited in claim 1, wherein said portion of said electrode extending into said effective luminous area bridges said area.

9. The semiconductor luminous element recited in claim 1, wherein said portion of said electrode extending into said effective luminous area has the form of a mesh covering said area.

10. The semiconductor luminous element recited in claim 1, wherein said portion of said electrode extending into said effective luminous area is arranged to avoid occluding a center of said area.

11. The semiconductor luminous element recited in claim 1, wherein said portion of said electrode extending into said effective luminous area has a form that avoids subdividing said area.

12. The semiconductor luminous element recited in claim 1, comprising a multilayer reflective film between said luminous layer and said second electrode.

13. A luminous element module comprising:
a semiconductor luminous element as recited in claim 1,
a component to protect said semiconductor luminous element; and
a terminal to supply current to said semiconductor luminous element.

14. A photoemissive device comprising:
a semiconductor luminous element as recited in claim 1 and a lens to convert light radiated by said semiconductor luminous element to the form of a beam.

15. The photoemissive device recited in claim 14, comprising a circuit related to production of light by said semiconductor luminous element.

16. The photoemissive device recited in claim 15, having a power supply to supply power to said circuit related to production of light.

17. A photocoupler comprising:
the semiconductor luminous element recited in claim 1;
a semiconductor photodetector;
a component which contains said semiconductor luminous element and said semiconductor photodetector; said photocoupler being constructed such that light emitted by said semiconductor luminous element strikes said semiconductor photodetector.

18. An encoder comprising:
the semiconductor luminous element recited in claim 1;
a position data board which modulates light emitted by said semiconductor element according to its position relative to said element; and
a photodetector which detects said light modulated by said position data board.

19. An encoder as recited in claim 18, wherein, based on an output of said photodetector, said encoder outputs position data concerning relative positions of said semiconductor luminous element and said position data board.

20. An optical detector comprising the photoemissive device recited in claim 14, which casts a beam onto an object, and a photodetector, which detects light modulated by said object.

21. The optical detector recited in claim 20, wherein, based on output signals from said photodetector, said optical detector outputs data concerning said object.

22. An optical data reader comprising:
the photoemissive device recited in claim 14;
a scanning device which scans a light beam emitted by said photoemissive device and causes said light beam to fall on an object upon which information has been optically encoded into a pattern; and
a photodetector which detects light reflected by said object.

23. The optical data reader recited in claim 22, wherein, based on output signals from said photodetector, said data reader reads out data contained in said pattern.

24. A printer comprising:
the photoemissive device recited in claim 14;
a scanning device which scans said beam emitted by said photoemissive device;
a printing device which prints documents based on said beam of light scanned by said scanning device; and
a control circuit which controls operation of said device.

25. An optical fiber module comprising:
the semiconductor luminous element recited in claim 1 and an optical fiber, and constructed such that light emitted by said semiconductor luminous element is conducted into said optical fiber.

26. A semiconductor luminous element comprising:
a luminous layer;
a first and a second electrode to supply current to said luminous layer, said first electrode being furnished on a first side of said element;
a confining means furnished on at least said first side operative to confine to a specific region an effective luminous area from which light generated from said luminous layer is radiated to an exterior of said element; and
an electrode extending from at least said first electrode device into said effective luminous area.

27. The semiconductor luminous element recited in claim 1, wherein said second electrode covers one entire surface of said luminous element.
